Europäisches Patentamt

European Patent Office

Office européen des brevets

(11) Publication number: 0 296 771
A2

# (12) EUROPEAN PATENT APPLICATION

(21) Application number: 88305573.3

(22) Date of filing: 17.06.88

(51) Int. Cl.⁴ $H01L\ 29/10$

The title of the invention has been amended (Guidelines for Examination in the EPO, A-III, 7.3).

(30) Priority: 25.06.87 IT 2103887

(43) Date of publication of application:
28.12.88 Bulletin 88/52

(84) Designated Contracting States:
DE FR GB NL SE

(71) Applicant: SGS-THOMSON
MICROELECTRONICS S.p.A.
Via C. Olivetti, 2
I-20041 Agrate Brianza (MI)(IT)

(72) Inventor: Foroni, Mario
Via Jacopo Foroni, 1
I-37067 Valeggio sul Mincio (VR)(IT)
Inventor: Bertotti, Franco
Via Don Gnocchi 29
I-20010 Milano(IT)
Inventor: Ferrari, Paolo
Via F. Cavallotti
14 21013 Gallarate (VA)(IT)

(74) Representative: Robinson, John Stuart et al
MARKS & CLERK 57/60 Lincoln's Inn Fields
London WC2A 3LS(GB)

(54) Semiconductor device with a buried layer, and method of manufacture.

(57) A semiconductor device with a thin epitaxial layer (2) forms a planar bipolar transistor of vertical p-n-p type with a buried layer (5) with differential doping. The thin layer (2) is formed by epitaxial growth on a substrate (1) which forms the collector of the transistor. The buried layer (5) extends both in the substrate (1) and in the thin layer (2) in a zone lying below a surface emitter region (4). The peripheral portions of the buried layer (5) have a greater thickness and concentration of impurities than the non-peripheral portions.

## SEMICONDUCTOR DEVICE AND METHOD OF MANUFACTURE

The present invention relates to a semiconductor device, such as a planar bipolar transistor of vertical p-n-p type with a thin epitaxial layer, and to a method of making such a device.

Current techniques for producing monolithically integrated circuits on a substrate of monocrystalline silicon, grown epitaxially with a layer of monocrystalline silicon, involve, as is known, the use of epitaxial layers which become thinner as the density of integration increases. The thinning down of the epitaxial layer entails, however, a reduction of the voltage values which the integrated circuit can withstand without drawbacks.

The problem is particularly evident with planar bipolar transistors of vertical p-n-p type, with a collector formed by the substrate and a base formed by a portion of suitable doped epitaxial layer located between a surface emitter region and the substrate. When the thickness of the epitaxial layer drops below a specific value, the effective base thickness is too small to ensure the maintenance of the transistor voltage, with subsequent breakdowns due to "punch-through" as known to persons skilled in the art.

The solution to this problem, when it is impossible to decrease the values of the voltages supplied to the integrated circuit comprising these transistors of vertical p-n-p type, is currently to carry out a selective enrichment with N type impurities in the zones of the base layer immediately adjacent to the emitter region. This method, however, entails process operations additional to those from which the other components of the integrated circuit have already been obtained, for instance other types of transistor or diode, with the result that the process is more expensive overall.

Transistors of vertical p-n-p type with their collector on the substrate are, however, advantageous because of their small size, particularly in circuit applications in which the collector of a p-n-p transistor must be connected to the point of the circuit with a lower electrical potential.

According to one aspect of the invention, there is provided a device as defined in the appended Claim 1.

According to another aspect of the invention, there is provided a method as defined in the appended Claim 5.

Preferred embodiments of the invention are defined in the other appended claims. .

It is thus possible to provide a planar bipolar transistor of vertical p-n-p type having a structure which allows its monolithic integration in semiconductor devices with a thin epitaxial layer in a way which is less expensive than in the prior art.

The invention will be further described, by way of non-limiting example, with reference to the accompanying drawings, in which:

Figure 1 is an enlarged vertical section through a semiconductor device with a thin epitaxial layer comprising a planar bipolar transistor of vertical p-n-p type constituting a preferred embodiment of the invention; and

Figure 2 is a perspective view of a vertical section through an intermediate structure for the production of the device of Figure 1.

The same reference letters and numerals are used for corresponding parts in the drawings.

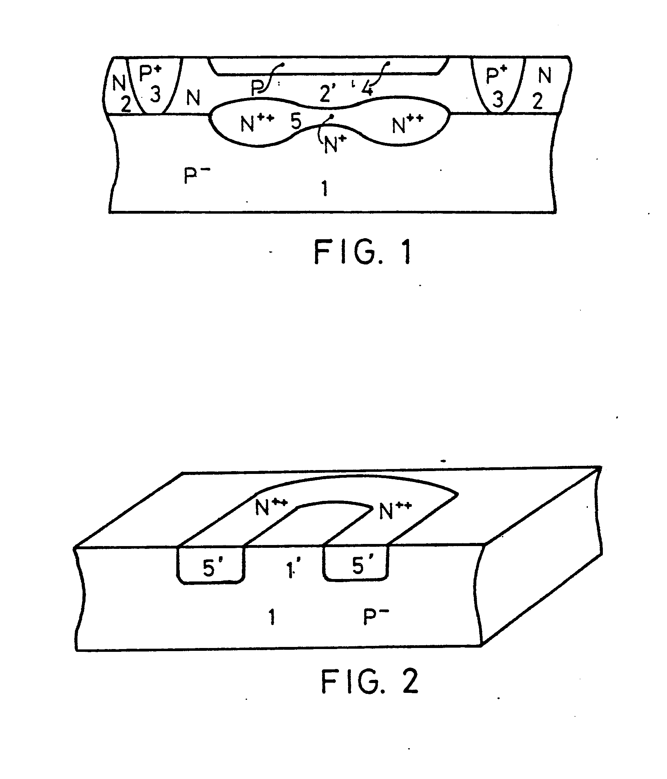

As shown in Figure 1, a semiconductor device with a thin epitaxial layer comprising a transistor of vertical p-n-p type is produced from a substrate 1 of monocrystalline silicon doped weakly with P type impurities, for example boron. The low concentration of impurities is shown in the drawings by the symbol $P^-$.

A thin layer 2 of silicon doped with N type impurities, for example phosphorus, is grown on the substrate 1. An isolation region 3, extending from the substrate 1 to the surface of the epitaxial layer 2, encloses a portion $2'$ of the epitaxial layer 2 in which there is defined a surface region 4 doped with P type impurities which extends into the epitaxial layer from its surface. In the area lying below the region 4 there is formed a buried layer 5 doped with N type impurities at a high concentration $(N^+)$, particularly in its peripheral portions $(N^{++})$. The buried layer 5 extends in part into the substrate 1 and in part into the portion $2'$ of the epitaxial layer 2.

The peripheral portions of the buried layer 5 have a thickness and, as mentioned above, a concentration of impurities which are greater than those of the central portion.

The isolation region 3 is formed in the epitaxial layer 2 by a first operation of deposition or ion implantation of P type impurities at a high concentration $(P^+)$ in predetermined areas of the substrate and the subsequent diffusion of these impurities into the epitaxial layer during its growth and by a second operation, when the growth of the epitaxial layer is complete, of deposition or ion implantation of P type impurities at a high concentration $(P^+)$ in areas of the surface of the layer 2 corresponding to the areas of the previous deposition or ion implantation and diffusion of these impurities within the epitaxial layer. The process parameters are selected so as to obtain the junction of the zones of diffusion from the substrate and the surface of the epitaxial layer in a single isolation region with a high concentration, $P^+$, of P type impurities.

The surface region 4 is obtained by using an operation similar to the second operation to form the isolation region 3, by depositing or implanting P type impurities in predetermined areas of the surface of the epitaxial layer and diffusing them into the epitaxial layer itself.

The buried layer 5 is formed by implanting or depositing N type impurities at a high concentration ($N^{++}$) in a first predetermined area of the substrate 1 all round a second predetermined area of the substrate and diffusing these impurities in the substrate 1 in order to obtain, as shown in Figure 2, a region $5'$ which is heavily doped with N type impurities ($N^{++}$) which extends from the surface of the substrate into the substrate around a zone $1'$ of the substrate. The initial doping area and the depth of diffusion of the region $5'$ in the substrate are calculated such that further diffusion of the impurities in the substrate during the growth of the epitaxial layer also takes place in the zone $1'$. Impurities are also diffused from the region $5'$ into the epitaxial layer.

Examining the structure shown in Figure 1, the surface region 4 forms the emitter of a transistor of vertical p-n-p type, whose collector is formed by the substrate 1 and whose base is formed by the isolated portion $2'$ of the epitaxial layer 2 and by the buried layer 5. Figure 1 does not show further parts, such as protection layers and contacts, which may, however, be produced in one of the many ways known to persons skilled in the art.

The presence of a buried layer 5 doped with the same type of impurities as the epitaxial layer 2, but with a somewhat higher concentration of these impurities, makes it possible substantially to improve the voltage rating of the device and to avoid "punch-through" phenomena even when the epitaxial layer is extremely thin. At the same time, the thinning down of the central portion of the buried layer 5 together with a predetermined reduction of the concentration of impurities makes it possible readily to regulate the gain of the transistor.

The maximum and minimum thicknesses of the buried layer 5 and the relative maximum and minimum concentrations of impurities are simply regulated by the definition of the doping area on the surface of the substrate around an area in which there is no doping, and by the determination of the doping parameters already calculated for the implementation of the other structures contained in the integrated circuit in which the transistor of vertical p-n-p type is to be included.

The definition of the doping area may be carried out by a masking operation already included in the process and even the doping operation in the predetermined area may coincide with a doping operation already included in the process. There is thus little or no increase in production costs. It is essential, however, that the doping area needed for the production of the buried layer 5 is defined such that the undoped area contained therein has a maximum width equal at most to twice the extension of the lateral diffusion region of the impurities implanted in the doping area, this lateral diffusion being due both to the diffusion operation in the substrate carried out before the epitaxial growth and to the subsequent diffusion of the impurities during the epitaxial growth of the thin layer. This subsequent diffusion takes place both in the substrate and in the thin epitaxial layer. This provides a continuous buried layer with conductivity of the same type as that of the thin epitaxial layer, but with a higher concentration of impurities.

Although a single embodiment of the invention has been described and illustrated, many variations are possible without departing from the scope of the invention. For instance, instead of a single zone, a plurality of zones having a reduced thickness and concentration of impurities with respect to the periphral portions of the layer could be provided in the buried layer. In addition, the initial doping area for the formation of the buried layer could be formed by portions of area which are separate, but still have, however, a maximum spacing from one another such as to enable the formation of a continous buried layer after the diffusion of the impurities.

## Claims

1. A monolithically integrated semiconductor device comprising: a substrate (1) having a first type of conductivity ($P^-$) and bounded by a first major surface of the device; a thin layer (2) having a second type of conductivity (N) opposite to the first and bounded by a second major surface of the device; an isolation region (3) having the first type of conductivity ($P^+$), extending from the substrate (1) to the second major surface of the chip, and bounding an isolated portion ($2'$) of the thin layer (2) extending from the substrate (1) to the second major surface; and a surface region (4) having the first type of conductivity (P), extending into the isolated portion ($2'$) from the second major surface, and being located in the isolated portion ($2'$), characterized by further comprising a buried layer (5) having the second type of conductivity ($N^+$, $N^{++}$) and extending into the substrate (1) and into the isolated portion ($2'$) of the thin layer (2) in a zone lying below the surface region (4), the buried layer (5) having peripheral portions with a thickness which is substantially greater than that of at least one non-peripheral portion of the buried layer (5), the concentration of impurities ($N^{++}$) arranged to provide the second type of conductivity in the peripheral portions being greater than the concentration of impurities ($N^+$) arranged to provide the second type of conductivity in the at least one non-peripheral portion of the buried layer (5).

2. A device as claimed in Claim 1, characterized in that the first type of conductivity is provided by P type impurities and the second type of conductivity is provided by N type impurities.

3. A device as claimed in Claim 2, characterized by providing a planar bipolar transistor of vertical p-n-p type in which the surface region (4) is the emitter, the substrate (1) is the collector, and the isolated portion (2') of the thin layer (2) together with the buried layer (5) is the base.

4. A device as claimed in anyone of the preceding claims, characterized by being included in a monolithically integrated circuit.

5. A method of making a device as claimed in Claim 1, comprising forming the thin layer (2) on the substrate (1) by epitaxial growth, forming the isolation region (3) which bounds the isolated portion (2') of the thin layer (2), and forming the surface region (4) in the isolated portion (2') of the thin layer (2), characterized in that the buried layer (5) is formed by doping a first predetermined area of the substrate (1) using impurities arranged to provide the second type of conductivity around at least a second predetermined area in which there is no doping, preliminary diffusion of the impurities into the substrate and into the thin layer (2) during the epitaxial growth of the thin layer (2), the maximum width of the second area being less than or equal to twice the extension of the region of lateral diffusion of the impurities, with which doping has been carried out in the first predetermined area, due both to the preliminary diffusion into the substrate and to the subsequent diffusion into the substrate (1) and into the thin layer (2) during the epitaxial growth.

6. A method as claimed in Claim 5, characterized in that the first predetermined area of the substrate (1) is formed by a plurality of portions of area which are separate and have a maximum spacing from one another equal at most to twice the extension of the region of lateral diffusion of the impurities with which doping has been carried out in the first predetermined area.

FIG. 1

FIG. 2